# EUROPEAN PATENT APPLICATION

(11) **EP 4 718 992 A1**
(43) Date of publication of application: **01.04.2026**
(21) Application number: 25193455.0
(22) Date of filing: 01.08.2025
(51) Int. Cl.: H10D 84/01, H10D 30/00, H10D 84/83, H10D 84/85

(54) **FORKSHEET TRANSISTORS WITH DIELECTRIC SPINE HAVING AN AIRGAP**

(30) Priority: 25.09.2024 US 202418895837
(71) Applicant: INTEL Corporation, Santa Clara, CA 95054 (US)
(72) Inventor: Koh, Shao-Ming, Mountain View OR, 94041 (US); Jayanti, Srikant, San Leandro CA, 94579 (US); Lindert, Nick, Portland OR, 97229 (US); Naskar, Sudipto, Portland OR, 97229 (US)
(74) Representative: Samson & Partner Patentanwälte mbB

(57) **Abstract**

Techniques are provided herein to form semiconductor devices that include forksheet transistors with a self-aligned dielectric spine having an airgap. The airgap may constitute a majority of the total volume of the dielectric spine, this lowering the dielectric constant of the dielectric spine and decreasing parasitic capacitance. In an example, first and second semiconductor devices have first and second semiconductor regions, respectively, extending in a first direction between corresponding source and drain regions. The first and second semiconductor regions may include any number of nanosheets. A dielectric spine extends in the first direction between the first and second semiconductor regions. The dielectric spine includes a dielectric liner adjacent to the sides of the first and second semiconductor regions. A remaining volume of the dielectric spine at least partially bound by the dielectric liner includes an airgap. A dielectric cap structure may be included over the airgap.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain device structures used to isolate adjacent transistors becomes challenging. Accordingly, there remain a number of non-trivial challenges with respect to forming semiconductor devices.

### BRIEF DESCRIPTION OF THE DRAWINGS

Figures 1A and 1B are cross-sectional and plan views, respectively, of some semiconductor devices that illustrate forksheet transistors with a dielectric spine having an airgap, in accordance with an embodiment of the present disclosure.
Figures 2A - 2N are cross-sectional views that illustrate various stages in an example process for forming semiconductor devices having forksheet transistors with a dielectric spine having an airgap, in accordance with some embodiments of the present disclosure.
Figure 3 is a cross-sectional view of semiconductor devices having forksheet transistors with a dielectric spine having an airgap and a conductive bridge over the dielectric spine, in accordance with an embodiment of the present disclosure.
Figure 4 illustrates a cross-sectional view of a chip package containing one or more semiconductor dies as variously described herein, in accordance with some embodiments of the present disclosure.
Figure 5 is a flowchart of a fabrication process for semiconductor devices having forksheet transistors with a dielectric spine having an airgap, in accordance with an embodiment of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include forksheet transistors with a self-aligned dielectric spine having an airgap. The airgap may constitute a majority of the total volume of the dielectric spine, this lowering the dielectric constant of the dielectric spine and decreasing parasitic capacitance. In an example, first and second semiconductor devices have first and second semiconductor regions, respectively, extending in a first direction between corresponding source and drain regions. A first gate structure extends in a second direction over the first semiconductor regions, and a second gate structure extends in the second direction over the second semiconductor regions. The first and second semiconductor regions may each include any number of nanosheets (or more generally, semiconductor bodies), with the first and second gate structures extending around three sides of each of the semiconductor bodies of the first and second semiconductor regions, respectively. A dielectric spine extends in the first direction directly between the first and second semiconductor regions, although in some cases there may be an intervening gate dielectric layer between the semiconductor regions and the dielectric spine. The dielectric spine includes a dielectric liner along its outer surface. According to some embodiments, a remaining volume of the dielectric spine at least partially bound by the dielectric liner is devoid of material, thus forming an airgap. The airgap may be filled with one or more gasses (e.g., oxygen, nitrogen), or be devoid of gas. The top of the dielectric spine includes a dielectric cap structure over the airgap. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. One such structure is the dielectric spine of a forksheet transistor arrangement. In more detail, the dielectric spine separates gate structures and semiconductor bodies (sometimes called nanosheets or nanoribbons) on either side of the dielectric spine. The semiconductor bodies of semiconductor devices on either side of the dielectric spine abut the sides of the dielectric spine, such that the gate does not extend completely around the semiconductor bodies. This structure allows the forksheet transistors to be patterned very close together (e.g., with only the dielectric spine between them). However, due to the closely packed nature of the forksheet transistors, shorting can be a problem if the integrity of the dielectric spine degrades during fabrication. In more detail, the dielectric spine is formed fairly early in the fabrication process (just after fin formation), which requires protecting the dielectric material through several subsequent processing operations, such as source and drain processing that includes deposition and etch processes used to form internal gate spacers. But protecting the dielectric spine is challenging and the subsequent fabrication processes often result in portions of the dielectric spine being etched away. To deal with this issue, the dielectric spine is often fabricated using high-k dielectric materials (e.g., silicon nitride) that are generally more robust (e.g., etch resistant) in withstanding later fabrication processes. However, the high-k materials cause in increase in the parasitic capacitance of the structure, which adversely affects transistor performance.

Thus, and in accordance with an embodiment of the present disclosure, techniques are provided herein to form a self-aligned spine between forksheet transistors that includes a large airgap through a majority of its volume, this drastically decreasing the dielectric constant of the spine structure. According to some embodiments, two semiconductor fins of alternating semiconductor material are formed that run parallel to one another along a first direction and are relatively close to one another (e.g., within 20 nm of each other) along an orthogonal second direction. Each fin of semiconductor material will ultimately form a transistor on each side of a forksheet arrangement. A sacrificial spine is formed between the adjacent fins and remains until after various additional fabrication procedures are performed, such as the formation of source or drain regions at the ends of the fins, the release of nanosheets within each of the fins, and the formation of gate structures over the released nanosheets.

According to some embodiments, the sacrificial spine material is removed following the formation of the gate structures to leave behind a trench recess between the adjacent devices. A dielectric liner is formed within the trench recess and the remaining volume of the trench recess is filled with a volatile material. A porous liner is formed over the top of the volatile material, such that the volatile material is surrounded by the dielectric liner and the porous liner. An annealing operation is then performed to sublimate the volatile material after which it escapes through the porous liner to leave behind an airgap bound by the dielectric liner and the porous liner. It should be understood that the term "airgap" as used herein may refer to any region that is devoid of solid material. The airgap may include any concentration of inert gases such as nitrogen or argon, and/or may be under vacuum pressure. A dielectric cap may be formed over the porous liner to improve the integrity of the spine. Since the airgap has a dielectric constant near 1.0, the spine has an overall low dielectric constant compared to spines formed from solid materials, and especially when compared to spines formed primarily from high-k materials, such as silicon nitride.

According to an embodiment, an integrated circuit includes a first semiconductor device having a first semiconductor material extending in a first direction from a first source or drain region and a first gate structure extending in a second direction over the first semiconductor material, a second semiconductor device having a second semiconductor material extending in the first direction from a second source or drain region and a second gate structure extending in the second direction over the second semiconductor material, and a spine between the first semiconductor material and the second semiconductor material and between the first gate structure and the second gate structure. The spine includes a dielectric liner having a first portion on the first semiconductor material and a second portion on the second semiconductor material, and an airgap extending across the second direction from the first portion of the dielectric liner to the second portion of the dielectric liner.

According to an embodiment, an electronic device includes a chip package having one or more dies. At least one of the one or more dies includes a first semiconductor material extending in a first direction between a first source or drain region and a second source or drain region, a first gate structure extending in a second direction over the first semiconductor material, a second semiconductor material extending in the first direction between a third source or drain region and a fourth source or drain region, a second gate structure extending in the second direction over the second semiconductor material, and a spine between the first semiconductor material and the second semiconductor material, between the first source or drain region and the third source or drain region, and between the second source or drain region and the fourth source or drain region. The spine includes a dielectric liner having a first portion on the first semiconductor material and a second portion on the second semiconductor material, and an airgap extending across the second direction from the first portion of the dielectric liner to the second portion of the dielectric liner.

According to an embodiment, an integrated circuit includes a first semiconductor device having first semiconductor material, a second semiconductor device having second semiconductor material, and a spine between and contacting the first semiconductor material and the second semiconductor material. The spine includes a first dielectric liner along sidewalls of the spine, a second dielectric liner at a top portion of the spine, and a region devoid of solid material within a central portion of the spine and bound by the first dielectric liner and the second dielectric liner.

According to another embodiment, a method of forming an integrated circuit includes forming a first fin comprising first semiconductor material and a second fin comprising second semiconductor material, wherein the first fin and the second fin are adjacent and extend parallel to one another along a first direction; forming a first sacrificial material between the first fin and the second fin such that the first sacrificial material extends from the first semiconductor material to the second semiconductor material along a second direction substantially orthogonal to the first direction; forming a sacrificial gate over the first fin and the second fin along the second direction; forming first source or drain regions at opposite ends of the first fin and second source or drain regions at opposite ends of the second fin; replacing the sacrificial gate with one or more gate structures that extend over the first semiconductor material and the second semiconductor material along the second direction; removing the first sacrificial material from between the first semiconductor material and the second semiconductor material to form a trench recess; forming a first dielectric liner within the trench recess; forming a second sacrificial material within a remaining volume of the trench recess on the dielectric liner; forming a second dielectric liner on at least a portion of a top surface of the second sacrificial material; and annealing the integrated circuit to remove the second sacrificial material while maintaining the second dielectric liner.

The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a dielectric spine of a forksheet structure having an airgap that extends nearly the entire width of the dielectric spine (e.g., bound by the dielectric liner on the edges of the dielectric spine). In some embodiments, such tools may indicate a gate dielectric conformally around the nanosheets such that at least a portion of the gate dielectric is also present directly between the semiconductor nanosheets and on the dielectric spine. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

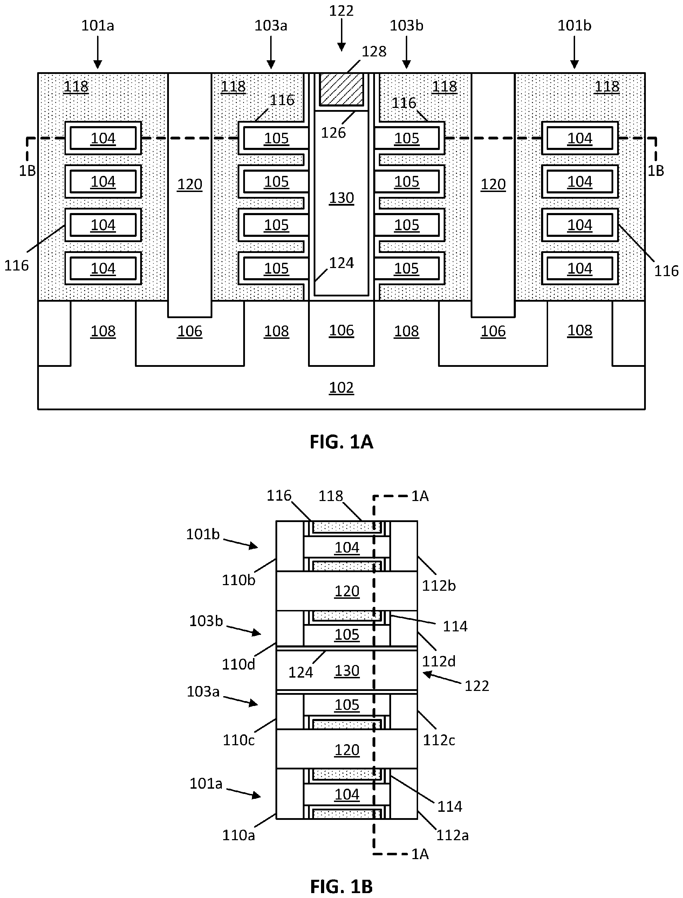

Figure 1A is a cross-sectional view taken across four example semiconductor devices 101a, 101b, 103a, and 103b, according to an embodiment of the present disclosure.

Figure 1B is a plan view of the semiconductor devices taken across the dashed line 1B-1B depicted in Figure 1A, and Figure 1A illustrates the cross-section taken across the dashed line 1A-1A depicted in Figure 1B. It should be noted that some of the material layers are not visible in the plan view of Figure 1B, given the location of the depicted cross-section.

According to some embodiments, semiconductor devices 101a and 101b may be gate-all-around (GAA) transistors, and semiconductor devices 103a and 103b are part of a forksheet structure or arrangement having a dielectric spine 122. Other transistor topologies and types (e.g., finFETs, planar transistors) can also be used in conjunction with the forksheet techniques and structures provided herein. According to some embodiments, a given semiconductor device can be formed as either a GAA transistor or as part of a forksheet arrangement based on its distance from adjacent semiconductor devices. Those that are formed relatively close together (e.g., semiconductor devices 103a and 103b) may form a forksheet arrangement while those formed further apart from adjacent devices (e.g., semiconductor devices 101a and 101b) may form GAA transistors or finFETs (e.g., tri-gate or double-gate). Further details regarding the formation of semiconductor devices 101a, 101b, 103a, and 103b are provided herein. Semiconductor devices 101a, 101b, 103a, and 103b represent a portion of an integrated circuit that may contain any number of similar semiconductor devices.

As can be seen, the semiconductor devices are formed on a substrate 102. Any number of semiconductor devices can be formed on substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and/or power routing.

Each of semiconductor devices 101a and 101b includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. In a similar fashion, each of semiconductor devices 103a and 103b includes one or more nanosheets 105 that extend parallel to one another along the first direction between corresponding source and drain regions. In general, the term nanoribbons refer to semiconductor regions used in a GAA structure that have a gate wrapped around all sides of the semiconductor regions within the gate trench, and the term nanosheets refer to semiconductor regions used in a forksheet structure that have a gate wrapped around only some of the sides of the semiconductor regions within the gate trench. The semiconductor material of nanoribbons 104 and nanosheets 105 may be formed from substrate 102. In some embodiments, semiconductor devices 101a, 101b, 103a, and 103b may each include fins with alternating layers of material (e.g., alternating layers of silicon and SiGe) that facilitates forming of the illustrated nanoribbons 104 and nanosheets 105 during a gate forming process where one type of the alternating layers is selectively etched away so as to liberate the other type of alternating layers within the channel region. The alternating layers can be blanket deposited and then etched into fins or deposited into fin-shaped trenches, according to some examples. In the examples shown, nanoribbons 104 and nanosheets 105 appear to have similar geometry. In other examples, nanoribbons 104 and nanosheets 105 may have different geometries, such as the example case where nanoribbons 104 are thicker (in the vertical direction) than nanosheets 105. In some such cases, nanosheets may be thinned during the gate formation process. In other such cases, the fins used to form nanoribbons 104 have a first geometry profile (configured to provide relatively taller nanoribbons), and nanosheets 105 have a second geometry profile (configured to provide relatively thinner nanosheets).

As can further be seen, adjacent semiconductor devices are separated at their base by a dielectric fill 106 that may include silicon dioxide. Dielectric fill 106 provides shallow trench isolation (STI) between adjacent subfin regions 108 of any adjacent semiconductor devices. Dielectric fill 106 can be any suitable dielectric material, such as silicon dioxide, aluminum oxide, or silicon oxycarbonitride.

According to some embodiments, subfin regions 108 comprise the same semiconductor material as substrate 102 and are adjacent to dielectric fill 106. According to some embodiments, nanoribbons 104 (or other semiconductor bodies) extend between a source and a drain region in the first direction to provide an active region for a GAA transistor (e.g., the semiconductor region beneath the gate), and nanosheets 105 extend between a source and a drain region in the first direction to provide an active region for a forksheet transistor. The source and drain regions are not shown in the cross-section of Figure 1A, but are seen in the top-down view of Figure 1B where nanoribbons 104 of semiconductor device 101a extend between a source region 110a and a drain region 112a, nanoribbons 104 of semiconductor device 101b extend between a source region 110b and a drain region 112b, nanosheets 105 of semiconductor device 103a extend between a source region 110c and a drain region 112c, and nanosheets 105 of semiconductor device 103b extend between a source region 110d and a drain region 112d. Figure 1B also illustrates spacer structures 114 that extend around the ends of nanoribbons 104 and nanosheets 105 and along sidewalls of the gate structures so as to isolate the gate structures from the neighboring source or drain regions. Spacer structures 114 may include a dielectric material, such as silicon nitride.

According to some embodiments, the source and drain regions 110a-d, 112a-d are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions 110a-d, 112a-d may include multiple layers such as liners and capping layers to improve contact resistance. In any such cases, the composition and doping of the source and drain regions 110a-d, 112a-d may be the same or different, depending on the type (e.g., n-type or p-type) of the transistors. For example, one transistor may be a p-type MOS (PMOS) transistor, and another transistor may be an n-type MOS (NMOS) transistor. Any number of source and drain configurations and materials can be used.

According to some embodiments, gate structures extend over the nanoribbons 104 and nanosheets 105 of the different semiconductor devices. For example, a first gate structure extends over nanoribbons 104 of semiconductor device 101a along a second direction across the page, a second gate structure extends over nanoribbons 104 of semiconductor device 101b along the second direction, a third gate structure extends over nanosheets 105 of semiconductor device 103a along the second direction, and a fourth gate structure extends over nanosheets 105 of semiconductor device 103b along the second direction. The second direction (across the page in Figure 1A) may be orthogonal to the first direction (into and out of page, in Figure 1A). Each gate structure includes a respective gate dielectric 116 and a gate electrode (or gate layer) 118. Gate dielectric 116 represents any number of dielectric layers present between nanoribbons 104/nanosheets 105 and gate electrode 118. Gate dielectric 116 may also be present on the surfaces of other structures within the gate trench, such as on a top surface of subfin region 108. Portions of gate dielectric 116 around nanosheets 105 may be present along sidewall surfaces of dielectric spine 122. Gate dielectric 116 may include any suitable gate dielectric material(s). In some embodiments, gate dielectric 116 includes a layer of native oxide material (e.g., silicon dioxide) on the nanoribbons 104 and nanosheets 105 making up the channel region of the devices, and a layer of high-k dielectric material (e.g., hafnium oxide) on the native oxide.

Gate electrode 118 may represent any number of conductive layers, such as any metal, metal alloy, or doped polysilicon layers. In some embodiments, gate electrode 118 includes one or more workfunction metals around nanoribbons 104 and nanosheets 105. In some embodiments, at least one of the semiconductor devices is a p-channel device that includes a workfunction metal having titanium around its nanoribbons 104 or nanosheets 105 and another semiconductor device is an n-channel device that includes a workfunction metal having tungsten around its nanoribbons 104 or nanosheets 105. Gate electrode 118 may also include a fill metal or other conductive material (e.g., tungsten, ruthenium, molybdenum, copper, aluminum) around the workfunction metals to provide the whole gate electrode structure.

According to some embodiments, adjacent gate structures may be separated along the second direction (e.g., across the page, left to right) by a gate cut 120, which acts like a dielectric barrier or wall between gate structures. Gate cut 120 extends vertically (e.g., in a third direction) through at least an entire thickness of the adjacent gate structure. In some embodiments, gate cut 120 also extends through an entire thickness of dielectric fill 106. According to some embodiments, gate cut 120 is formed from any number of dielectric materials. In some examples, gate cut 120 includes silicon nitride and may also include a core of silicon dioxide or silicon oxynitride. Gate cut 120 may have a top width along the second direction, for instance, between about 15 nm and about 30 nm.

According to some embodiments, adjacent semiconductor devices 103a and 103b are part of a forksheet arrangement with a dielectric spine 122 between them which similarly separates the adjacent gate structures around nanosheets 105 of each of semiconductor devices 103a and 103b. As shown, dielectric spine 122 extends vertically in the third direction through at least an entire thickness of the adjacent gate structures. Unlike gate cut 120, dielectric spine 122 is arranged close to nanosheets 105 along the second direction such that no part of gate electrode 118 exists between dielectric spine 122 and the edges of nanosheets 105 along the second direction. In some embodiments, at least a portion of gate dielectric 116 wraps around all sides of nanosheets 105 such that the at least a portion of gate dielectric 116 is arranged directly between dielectric spine 122 and nanosheets 105 along the second direction. In some embodiments, dielectric spine 122 directly contacts the sides of nanosheets 105.

Both gate cut 120 and dielectric spine 122 also extend in the first direction as seen in Figure 1B such that they each cut across at least the entire width of the gate trench. According to some embodiments, gate cut 120 and/or dielectric spine 122 may also extend further past spacer structures 114. In some examples, gate cut 120 and/or dielectric spine 122 extends across more than one gate trench in the first direction (e.g., cutting through more than one gate structure running parallel along the second direction).

According to some embodiments, dielectric spine 122 includes a dielectric liner 124 along its outside edges. Dielectric liner 124 may be any suitable dielectric material, such as silicon nitride, silicon oxynitride, or silicon carbide. Dielectric liner 124 may be a high-k dielectric material to withstand multiple fabrication processes occurring to materials around it. According to some embodiments, dielectric liner 124 has a thickness of less than 5 nm, such as between 1 nm and 3 nm. A dielectric layer 126 is provided at a top portion of dielectric spine 122 and may be part of a cap structure that also includes dielectric fill 128. Together, dielectric layer 126 and dielectric fill 128 plug the top of dielectric spine 122. According to some embodiments, dielectric layer 126 includes a porous dielectric material, such as any of silicon dioxide, aluminum oxide, silicon nitride, silicon oxycarbonitride, silicon oxycarbide, or silicon carbonitride. Dielectric layer 126 may have a thickness, for example, of less than 5 nm, such as between 1 nm and 3 nm. Dielectric fill 128 may be any suitable dielectric material, such as silicon nitride, silicon oxynitride, or silicon carbonitride, to name a few examples.

According to some embodiments, dielectric spine 122 includes an airgap 130 that is bound by dielectric liner 124 and dielectric layer 126. Accordingly, airgap 130 may extend across the second direction from a first portion of dielectric liner 124 (e.g., a portion on or directly adjacent to nanosheets 105 of semiconductor device 103a) to as second portion of dielectric liner 124 (e.g., a portion on or directly adjacent to nanosheets 105 of semiconductor device 103b). In some embodiments, airgap 130 may also extend along the third direction between dielectric layer 126 and a portion of dielectric liner 124 at the bottom of dielectric spine 122. As noted above, airgap 130 may be devoid of solid material (e.g., only gases are present). In some examples, inert gases such as argon or nitrogen may be present within airgap 130.

### Fabrication Methodology

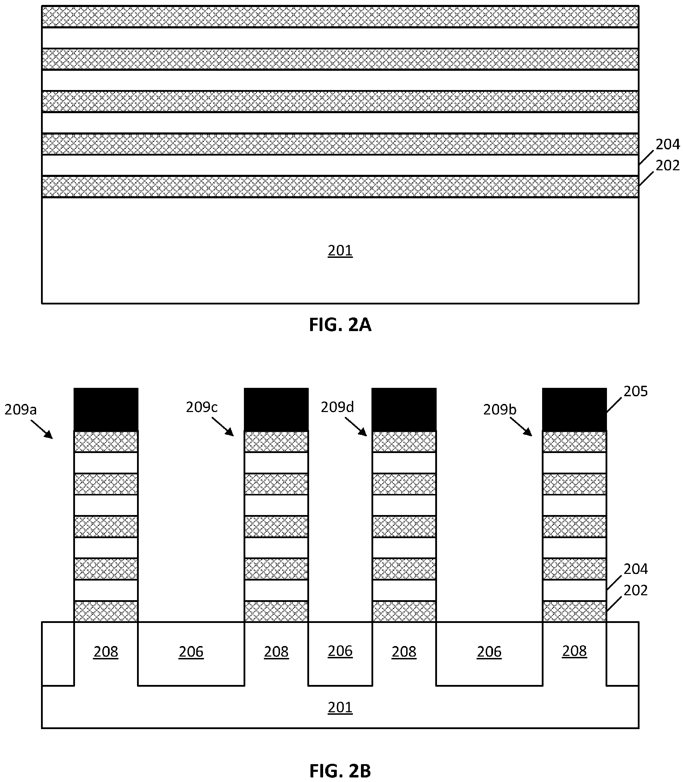

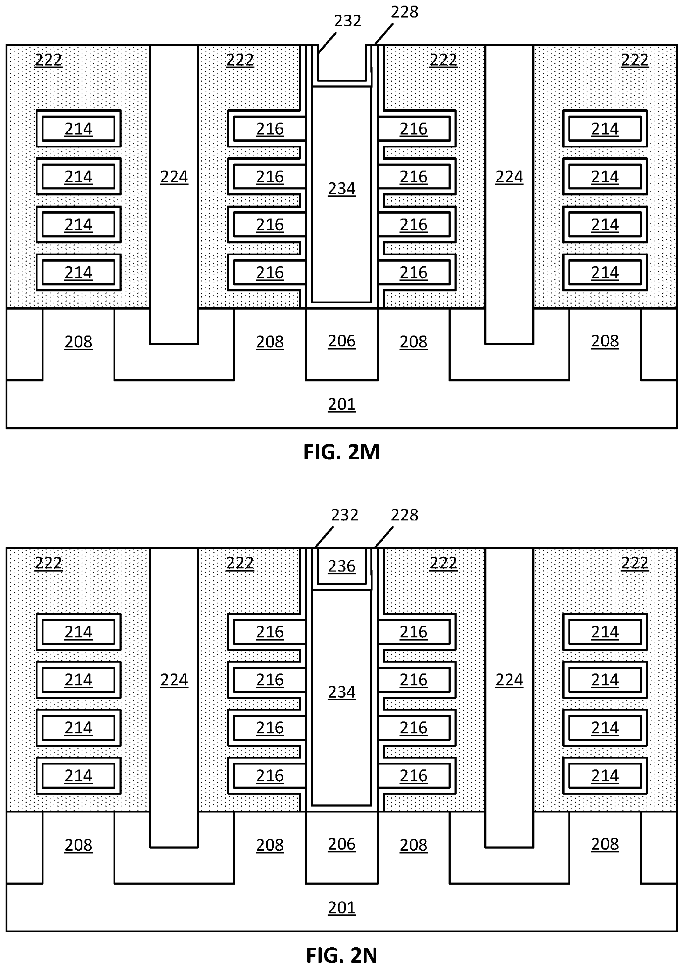

Figures 2A - 2N include cross-sectional views that collectively illustrate an example process for forming an integrated circuit with semiconductor devices having a forksheet dielectric spine with a relatively large airgap, in accordance with an embodiment of the present disclosure. Each figure shows an example structure that results from the process flow up to that point in time, so the depicted structure evolves as the process flow continues, culminating in the structure shown in Figure 2N, which is similar to the structure shown in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated. Although the fabrication of a single dielectric spine is illustrated in the aforementioned figures, it should be understood that any number of similar dielectric spines as part of forksheet structures can be fabricated across the integrated circuit using the same processes discussed herein.

Figure 2A illustrates a cross-sectional view taken through a substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA and forksheet transistor structures. Any number of alternating semiconductor layers 204 and sacrificial layers 202 may be deposited over substrate 201. The description above for substrate 102 applies equally to substrate 201.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

Figure 2B depicts the cross-section view of the structure shown in Figure 2A following the formation of a fin patterning layer 205 and the subsequent formation of fins 209a - 209d beneath fin patterning layer 205, according to an embodiment. Fin patterning layer 205 may be any suitable hard mask material such as a carbon hard mask (CHM) or any combination of material layers that can be easily removed following the etching process. Fin patterning layer 205 is patterned into rows to form corresponding rows of fins from the alternating layer stack of sacrificial layers 202 and semiconductor layers 204. The rows of fins extend lengthwise in a first direction (e.g., into and out of the page). Note that in the illustrated arrangement of fins, a distance along a second direction (e.g., across the page) between fins 209c and 209d is less than a distance between fin 209b and fin 209d and is less than a distance between fin 209a and fin 209c. In this example, fins 209c and 209d are patterned closer together to be part of a forksheet structure and fins 209a and 209b are patterned with a greater pitch between them and their neighboring fins to form GAA structures.

According to some embodiments, an anisotropic etching process through the layer stack continues into at least a portion of substrate 201. The etched portion of substrate 201 may be filled with a dielectric fill 206 that acts as shallow trench isolation (STI) between adjacent fins. Dielectric fill 206 may be any suitable dielectric material such as silicon dioxide. Subfin regions 208 represent remaining portions of substrate 201 between dielectric fill 206, according to some embodiments.

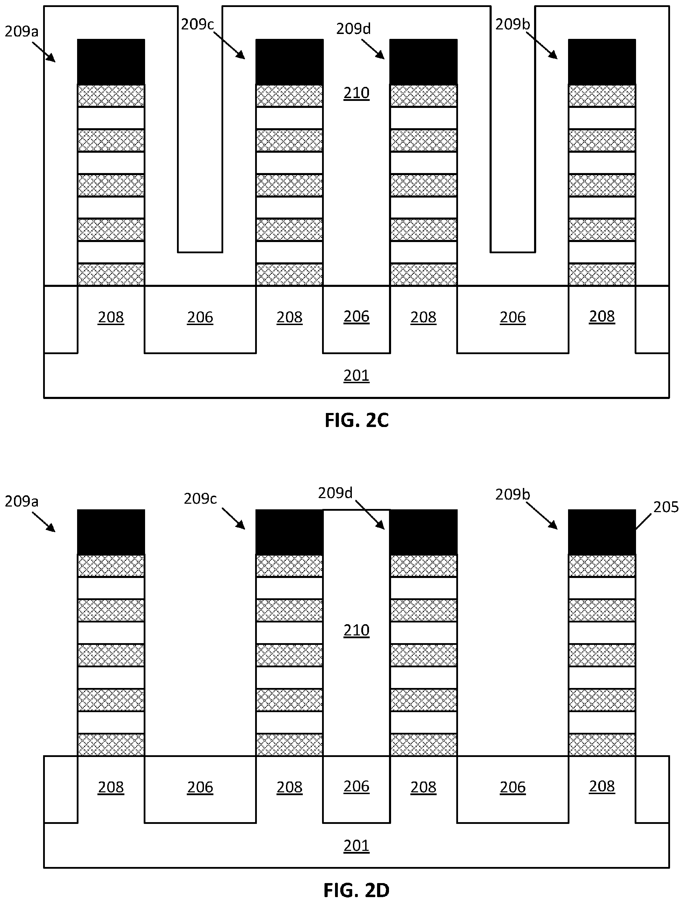

Figure 2C depicts the cross-section view of the structure shown in Figure 2B following the formation of a sacrificial spine material 210, according to some embodiments. Sacrificial spine material 210 may be deposited using any suitable conformal deposition process, such as CVD, PECVD, or ALD. Sacrificial spine material 210 may be any suitable material that can be safely removed at a later time without damaging surrounding structures. In some embodiments, sacrificial spine material 210 includes silicon dioxide or aluminum oxide. Note that due to the distances between the different fins, sacrificial spine material 210 substantially fills the region between fins 209c and 209d while leaving space between the further sets of fins (e.g., between fins 209a and 209c and between fins 209d and 209b).

Figure 2D depicts the cross-section view of the structure shown in Figure 2C following an etch-back process to remove sacrificial spine material 210 from around fins 209a and 209b while leaving sacrificial spine material 210 between fins 209c and 209d, according to some embodiments. An isotropic etching process may be used to remove all exposed portions of sacrificial spine material 210. The portion of sacrificial spine material 210 between fins 209c and 209d is protected by those fins and thus remains after the other portions of sacrificial spine material 210 have been removed. According to some embodiments, a top surface of sacrificial spine material 210 is substantially coplanar with or beneath a top surface of fin patterning layer 205.

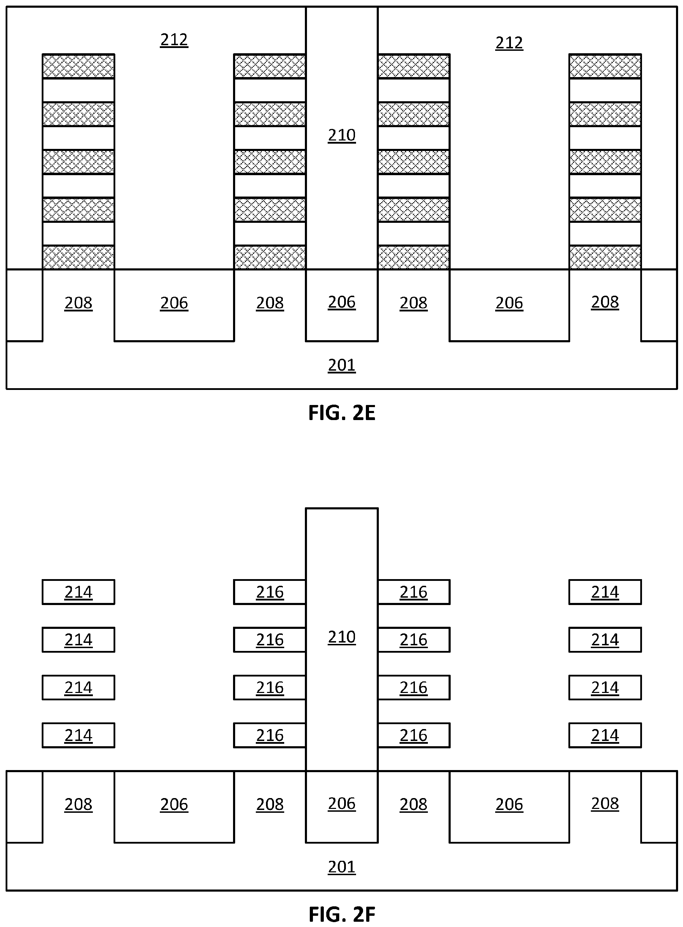

Figure 2E depicts the cross-section view of the structure shown in Figure 2D following the formation of a sacrificial gate 212 extending across the fins in the second direction (e.g., across the page), according to some embodiments. Sacrificial gate 212 may extend across the fins in a second direction that is orthogonal to the first direction. According to some embodiments, fin patterning layer 205 may be removed using any suitable isotropic etching technique prior to the formation of sacrificial gate 212. According to some embodiments, the sacrificial gate material is formed in parallel strips across the integrated circuit and removed in all areas not protected by a gate masking layer. Sacrificial gate 212 may be any suitable material that can be selectively removed without damaging the semiconductor material of the fins. In some examples, sacrificial gate 212 includes polysilicon. In some cases, sacrificial gate 212 may also include a dielectric liner, such as an oxide of the fin material, which covers the exposed surfaces of the fins. According to some embodiments, a top surface of sacrificial gate 212 may be polished using, for example, chemical mechanical polishing (CMP) such that it is substantially coplanar with a top surface of sacrificial spine material 210.

Following the formation of sacrificial gate 212 (and prior to replacement of sacrificial gate 212 with a metal gate), additional semiconductor device structures are formed that are not shown in these cross-sections. These additional structures include spacer structures on the sidewalls of sacrificial gate 212 and source and drain regions on either ends of each of the fins. The formation of such structures can be accomplished using any number of processing techniques.

Figure 2F depicts the cross-section view of the structure shown in Figure 2E following the removal of sacrificial gate 212 and the removal of sacrificial layers 202, according to some embodiments. In examples where any gate masking layers are still present, they may also be removed at this time. Once sacrificial gate 212 is removed, the fins that had been beneath sacrificial gate 212 are exposed.

According to some embodiments, sacrificial layers 202 are selectively removed to release nanoribbons 214 and nanosheets 216 that extend between corresponding source or drain regions. Each vertical set of nanoribbons 214 and nanosheets 216 represents the semiconductor or channel region of a different semiconductor device. Sacrificial gate 212 and sacrificial layers 202 may be removed using the same isotropic etching process or different isotropic etching processes.

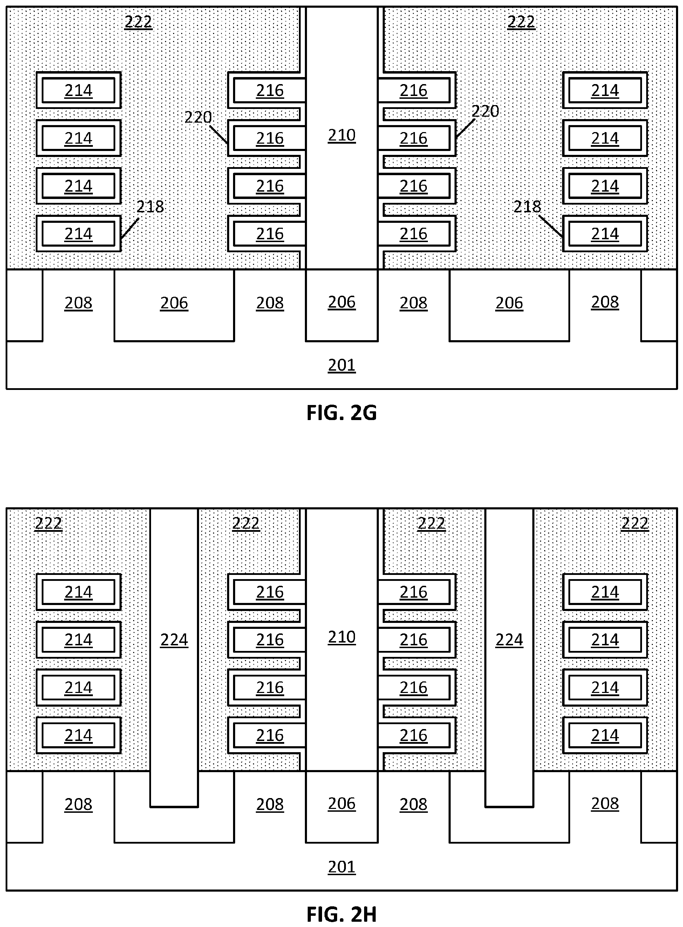

Figure 2G depicts the cross-section view of the structure shown in Figure 2F following the formation of a gate structure and subsequent polishing, according to some embodiments. The gate structure includes a gate dielectric 218/220 and a conductive gate electrode 222. Gate dielectric 218 may be formed around all sides of nanoribbons 214 within the gate trench and gate dielectric 220 may be formed around only exposed sides of nanosheets 216 within the gate trench (e.g., not on the side directly adjacent to sacrificial spine material 210). Gate dielectric 218 and 220 may be substantially the same and formed together prior to the formation of gate electrode 222. The gate dielectric 218/220 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 218/220 includes a layer of hafnium oxide with a thickness between about 1 nm and about 5 nm. In some embodiments, gate dielectric 218/220 may include one or more silicates (e.g., titanium silicate, tungsten silicate, niobium silicate, and silicates of other transition metals). In some cases, gate dielectric 218/220 may include a first layer on nanoribbons 214 and nanosheets 216, and a second layer on the first layer. The first layer can be, for instance, an oxide of the semiconductor material of nanoribbons 214 and nanosheets 216 (e.g., silicon dioxide) and the second layer can be a high-k dielectric material (e.g., hafnium oxide). More generally, gate dielectric 218/220 can include any number of dielectric layers. According to some embodiments, gate dielectric 218/220 forms along all surfaces exposed within the gate trench, such as along inner sidewalls of the spacer structures, along the top surfaces of dielectric fill 206 and subfin regions 208. In some examples, portions of gate dielectric 220 may be formed on sidewall surfaces of sacrificial spine material 210, such as surfaces between nanosheets 216.

As noted above, gate electrode 222 can represent any number of conductive layers. The conductive gate electrode 222 may be deposited using electroplating, electroless plating, CVD, PECVD, ALD, or PVD, to name a few examples. In some embodiments, gate electrode 222 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 222 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of gate electrode 222) is planar with the top surface of other semiconductor elements, such as the spacer structures that define the gate trench. In some examples, masking can be used to facilitate processing of one gate structure type, while the locations of other gate structure types are masked off, and vice-versa.

Figure 2H depicts the cross-section view of the structure shown in Figure 2G following the formation of gate cuts 224, according to some embodiments. A reactive ion etching (RIE) process may be used to etch trenches through the gate structure within the gate trench. The trenches run lengthwise along the first direction (e.g., into and out of the page) and may cut across any number of additional gate trenches. According to some embodiments, the trenches are etched to a depth that is at least the entire height of gate electrode 222. In some examples, the trenches extend into a portion of dielectric fill 206 or into a portion of substrate 201.

According to some embodiments, the etched trenches are filled with one or more dielectric materials to form gate cuts 224. In some examples, the one or more dielectric materials include one or more high-k dielectric materials, such as silicon nitride, silicon oxycarbide, or silicon oxynitride. In some examples, gate cuts 224 include a dielectric liner and a dielectric fill on the dielectric liner, with the dielectric liner being a high-k dielectric material and the dielectric fill being a low-k dielectric material (e.g., silicon dioxide).

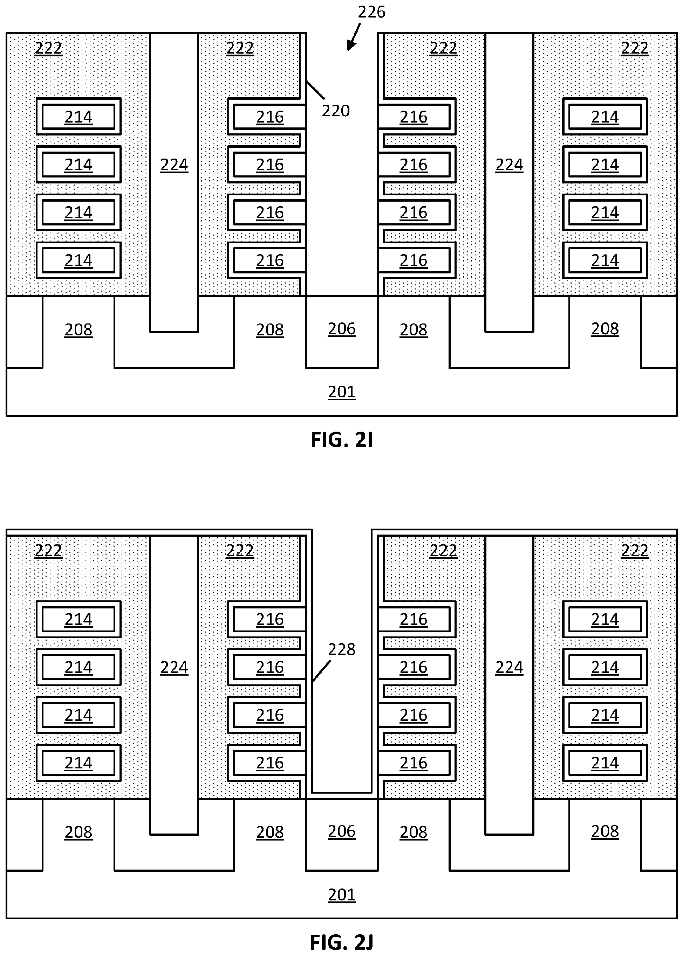

Figure 2I depicts the cross-section view of the structure shown in Figure 2H following the removal of sacrificial spine material 210, according to some embodiments. An isotropic etching process may be used to remove sacrificial spine material 210 leaving behind a spine recess 226 between nanosheets 216. Note that gate electrode 222 may be protected from the etching process by portions of gate dielectric 220 that had been present on the sidewalls of sacrificial spine material 210.

Figure 2J depicts the cross-section view of the structure shown in Figure 2I following the formation of a dielectric liner 228 along all sides of spine recess 226, according to some embodiments. Dielectric liner 228 may be conformally deposited using any suitable technique, such as ALD, CVD, or PECVD. Dielectric liner 228 may have a thickness, for example, of less than 5 nm, such as between 1 nm and 3 nm and may be any suitable high-k dielectric material. In some examples, dielectric liner 228 includes silicon nitride, silicon oxycarbide, or silicon oxynitride. Note that portions of dielectric liner 228 may be formed directly on sidewall surfaces of nanosheets 216.

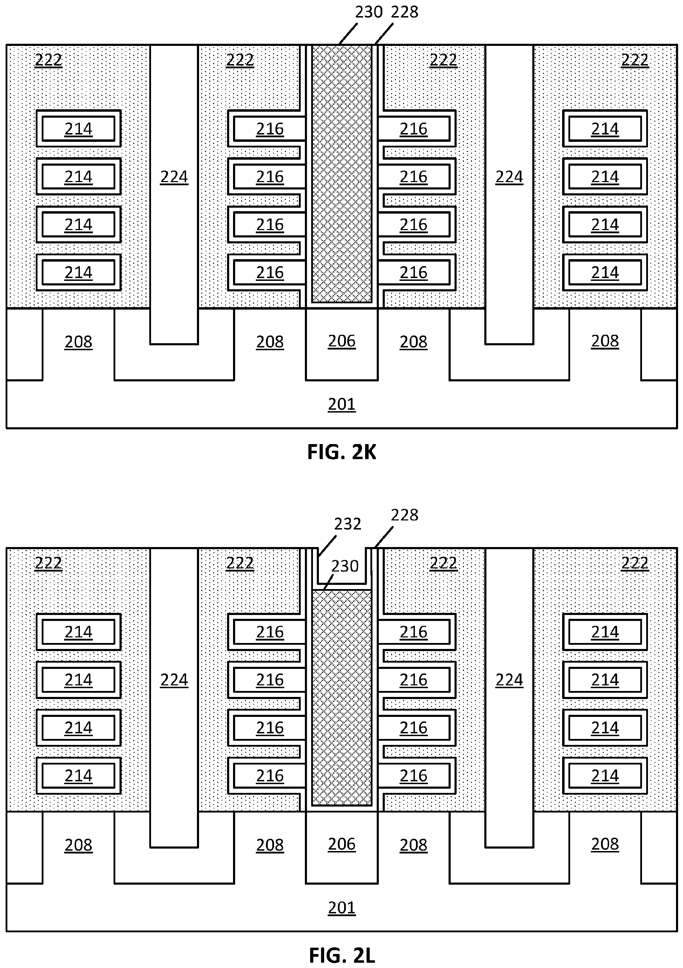

Figure 2K depicts the cross-section view of the structure shown in Figure 2J following the formation of another sacrificial material 230 within a remaining volume of spine recess 226, according to some embodiments. Sacrificial material 230 may be a volatile material that is formulated to sublimate at temperatures below around 400 °C. In some examples, a volatile polymer material is used for sacrificial material 230. Sacrificial material 230 may be deposited and the polished or etched back such that the top surface of sacrificial material 230 is coplanar with or recessed below a top surface of gate electrode 222. During this process, portions of dielectric liner 228 on the top of the structure may also be removed.

Figure 2L depicts the cross-section view of the structure shown in Figure 2K following further recessing of sacrificial material 230 and the formation of a dielectric layer 232, according to some embodiments. Any suitable isotropic etching process may be used to recess sacrificial material 230 below the top surface of gate electrode 222. In some examples, the top surface of sacrificial material 230 is recessed such that it is below the top surface of gate electrode 222 but above the topmost surface of nanosheets 216.

According to some embodiments, dielectric layer 232 is formed over the top surface of sacrificial material 230, such that sacrificial material 230 is bound on all sides between at least dielectric liner 228 and dielectric layer 232. Dielectric layer 232 may be a porous dielectric material having a pore size that is at least bigger than the sublimated molecules of sacrificial material 230. In some examples, dielectric layer 232 includes silicon dioxide, aluminum oxide, silicon nitride, silicon oxynitride, silicon oxycarbide, silicon carbonitride, or silicon oxycarbonitride. Dielectric layer 232 may have a similar or thinner thickness compared to dielectric liner 228. In some examples, dielectric layer 232 has a thickness of less than 5 nm, less than 3 nm, or between 1 nm and 3 nm.

Figure 2M depicts the cross-section view of the structure shown in Figure 2L following the removal of sacrificial material 230 leaving behind an airgap 234, according to some embodiments. The structure may be heated to a temperature between about 200 °C and 400 °C for anywhere from 30 minutes to 2 hours to cause sublimation of sacrificial material 230. The gaseous sacrificial material 230 may escape through the pores of dielectric layer 232. As a result, airgap 234 remains in the volume previously occupied by sacrificial material 230. According to some embodiments, airgap 234 extends along the second direction from one portion of dielectric liner 228 to another portion of dielectric liner 228. Airgap 234 may also extend along the third direction between a bottom portion of dielectric liner 228 and dielectric layer 232 at the top end of the spine structure. Airgap 234 may be fully encapsulated by dielectric liner 228 and dielectric layer 232. As noted above, airgap 234 may include trace amounts of gases such as nitrogen or argon.

Figure 2N depicts the cross-section view of the structure shown in Figure 2M following the formation of a dielectric plug 236 on dielectric layer 232 to form a cap structure at the top end of the dielectric spine, according to some embodiments. Dielectric plug 236 may be any suitable dielectric material, such as silicon nitride. In some examples, dielectric plug 236 is polished following deposition such that a top surface of dielectric plug 236 is substantially coplanar with a top surface of adjacent spacer structures or gate cuts 224.

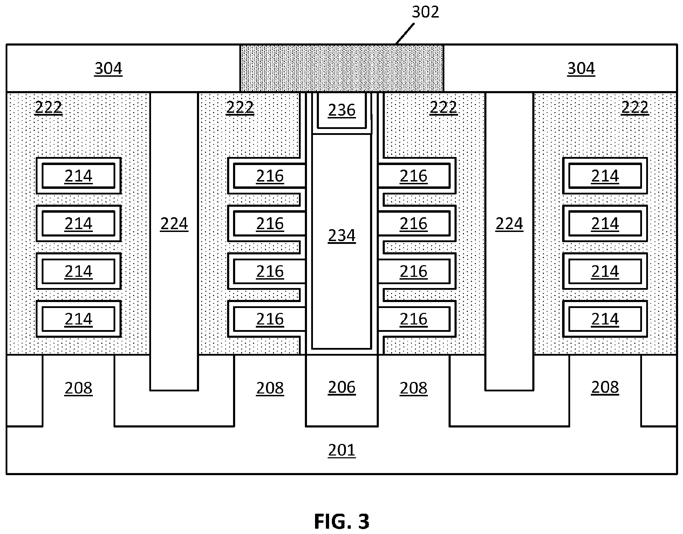

Figure 3 depicts another cross-section view of the structure shown in figure 2M following the optional formation of a conductive bridge 302 over the dielectric spine, according to some embodiments. Conductive bridge 302 connects the gate electrodes 222 between the forksheet devices on either side of the dielectric spine. According to some embodiments, a dielectric layer 304 is formed over the structure and conductive bridge 302 is formed through a portion of dielectric layer 304. Dielectric layer 304 may be part of a first interconnect layer of a topside interconnect region. Dielectric layer 304 may be any suitable dielectric material, such as silicon dioxide. Conductive bridge 302 may include any suitable conductive material, such as ruthenium, tungsten, cobalt, or molybdenum.

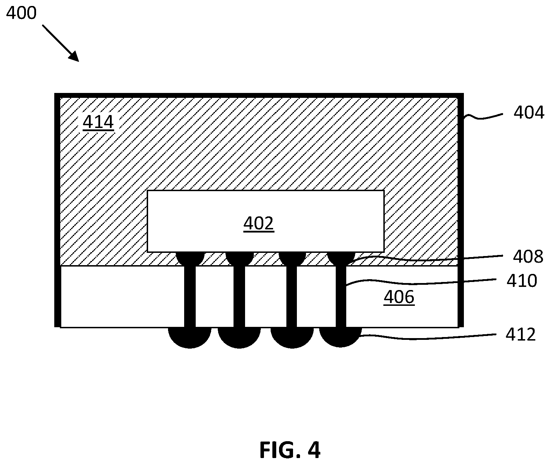

Figure 4 illustrates an example embodiment of a chip package 400, in accordance with an embodiment of the present disclosure. As can be seen, chip package 400 includes one or more dies 402. One or more dies 402 may include at least one integrated circuit having semiconductor devices, such as any of the semiconductor devices disclosed herein. One or more dies 402 may include any other circuitry used to interface with other devices formed on the dies, or other devices connected to chip package 400, in some example configurations.

As can be further seen, chip package 400 includes a housing 404 that is bonded to a package substrate 406. The housing 404 may be any standard or proprietary housing, and may provide, for example, electromagnetic shielding and environmental protection for the components of chip package 400. The one or more dies 402 may be conductively coupled to a package substrate 406 using connections 408, which may be implemented with any number of standard or proprietary connection mechanisms, such as solder bumps, ball grid array (BGA), pins, or wire bonds, to name a few examples. Package substrate 406 may be any standard or proprietary package substrate, but in some cases includes a dielectric material having conductive pathways (e.g., including conductive vias and lines) extending through the dielectric material between the faces of package substrate 406, or between different locations on each face. In some embodiments, package substrate 406 may have a thickness less than 1 millimeter (e.g., between 0.1 millimeters and 0.5 millimeters), although any number of package geometries can be used. Additional conductive contacts 412 may be disposed at an opposite face of package substrate 406 for conductively contacting, for instance, a printed circuit board (PCB). One or more vias 410 extend through a thickness of package substrate 406 to provide conductive pathways between one or more of connections 408 to one or more of contacts 412. Vias 410 are illustrated as single straight columns through package substrate 406 for ease of illustration, although other configurations can be used (e.g., damascene, dual damascene, through-silicon via, or an interconnect structure that meanders through the thickness of substrate 406 to contact one or more intermediate locations therein). In still other embodiments, vias 410 are fabricated by multiple smaller stacked vias, or are staggered at different locations across package substrate 406. In the illustrated embodiment, contacts 412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 412, to inhibit shorting.

In some embodiments, a mold material 414 may be disposed around the one or more dies 402 included within housing 404 (e.g., between dies 402 and package substrate 406 as an underfill material, as well as between dies 402 and housing 404 as an overfill material). Although the dimensions and qualities of the mold material 414 can vary from one embodiment to the next, in some embodiments, a thickness of mold material 414 is less than 1 millimeter. Example materials that may be used for mold material 414 include epoxy mold materials, as suitable. In some cases, the mold material 414 is thermally conductive, in addition to being electrically insulating.

### Methodology

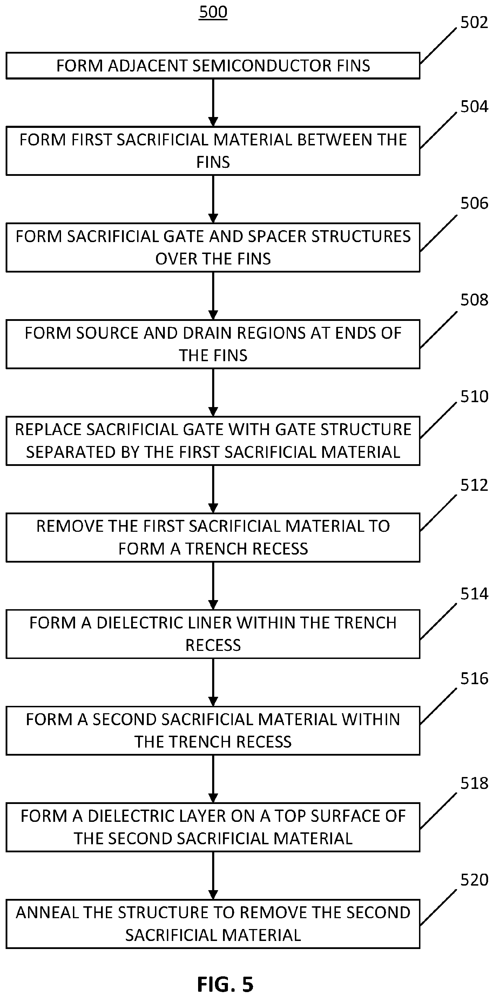

Figure 5 is a flow chart of a method 500 for forming at least a portion of an integrated circuit, according to an embodiment. Various operations of method 500 may be illustrated in Figures 2A - 2N. However, the correlation of the various operations of method 500 to the specific components illustrated in the aforementioned figures is not intended to imply any structural and/or use limitations. Rather, the aforementioned figures provide one example embodiment of method 500. Other operations may be performed before, during, or after any of the operations of method 500. For example, method 500 does not explicitly describe all processes that are performed to form common transistor structures. Some of the operations of method 500 may be performed in a different order than the illustrated order.

Method 500 begins with operation 502 where at least two parallel semiconductor fins are formed, according to some embodiments. According to some embodiments, the fins include alternating layers of material (e.g., alternating layers of silicon and SiGe) that facilitates forming of nanoribbons and nanosheets during a gate forming process where one type of the alternating layers are selectively etched away so as to liberate the other type of alternating layers within the channel region, so that gate-all-around (GAA) and forksheet processes can be carried out. The alternating layers can be blanket deposited and then etched into fins, or deposited into fin-shaped trenches. According to some embodiments, the fins also include a cap layer over each fin that may be used as a hard mask to define the locations of the fins during, for example, an RIE process. The cap layer may be a dielectric material, such as silicon nitride or any suitable hard mask material.

According to some embodiments, a dielectric layer is formed around subfin portions of the fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 500 continues with operation 504 where a first sacrificial material is formed between the fins. According to some embodiments, the first sacrificial material is conformally deposited over all fins on the substrate and then is etched back using, for example, an isotropic etching process. The etching process removes the first sacrificial material from around fins that are spaced far enough apart, but the first sacrificial material remains between fins that are positioned closer together as the fins protect the etchant from reaching the first sacrificial material between the fins. In some embodiments, the first sacrificial material includes silicon dioxide or aluminum oxide.

Method 500 continues with operation 506 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a crosshatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride. The top surface of the sacrificial gate may be polished to be substantially coplanar with a top surface of the first sacrificial material.

Method 500 continues with operation 508 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some examples, internal gates spacers are formed by way of the source drain recesses, prior to epitaxial growth of the source and drain regions. In some example embodiments, the source or drain regions are NMOS source or drain regions (e.g., epitaxial silicon) or PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 500 continues with operation 510 where the sacrificial gate is removed and replaced with a gate structure. The sacrificial gate may be removed using an isotropic etching process that selectively removes all of the material from the sacrificial gate, thus exposing the various fins between the set of spacer structures. According to some embodiments, any sacrificial layers within the exposed fins between the spacer structures may also be removed to release nanoribbons or nanosheets (e.g., directly adjacent to the first sacrificial material) of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples. The first sacrificial material may directly separate a first gate structure from a second gate structure, thus acting like a dielectric spine between nanosheets abutting either side of the first sacrificial material.

Method 500 continues with operation 512 where the first sacrificial material is removed to form a trench recess between the nanosheets of adjacent devices. According to some embodiments, an isotropic etching process is used to remove the first sacrificial material. The first sacrificial material includes a material that can be safely removed without damaging surrounding materials.

Method 500 continues with operation 514 where a dielectric liner is formed within the trench recess. The dielectric liner may be conformally deposited using any suitable technique, such as ALD, CVD, or PECVD. The dielectric liner may have a thickness, for example, of less than 5 nm, such as between 1 nm and 3 nm and may be any suitable high-k dielectric material. In some examples, the dielectric liner includes silicon nitride, silicon oxycarbide, or silicon oxynitride. In some examples, portions of the dielectric liner form directly on exposed sidewall surfaces of the nanosheets in the trench recess.

Method 500 continues with operation 516 where a second sacrificial material is formed within a remaining volume of the trench recess. According to some embodiments, the second sacrificial material is formed on the dielectric liner within the trench recess. The second sacrificial material may be a volatile material that is formulated to sublimate at temperatures below around 400 °C. In some examples, a volatile polymer material is used for the second sacrificial material. The second sacrificial material may be deposited and then polished or etched back such that the top surface of the second sacrificial material is coplanar with or recessed below a top surface of the gate electrode or the adjacent spacer structures.

Method 500 continues with operation 518 where a dielectric layer is formed on the top surface of the second sacrificial material. According to some embodiments, the dielectric layer is a porous dielectric material having a pore size that is at least bigger than the sublimated molecules of the second sacrificial material. In some examples, the dielectric layer includes silicon dioxide, aluminum oxide, silicon nitride, silicon oxynitride, silicon oxycarbide, silicon carbonitride, or silicon oxycarbonitride. The dielectric layer may have a similar or thinner thickness compared to the dielectric liner. In some examples, the second sacrificial material is further recessed within the trench recess prior to the formation of the dielectric layer to control the height of the eventual airgap. According to some embodiments, the second sacrificial material is completely encapsulated by at least the dielectric liner and the dielectric layer within the trench recess.

Method 500 continues with operation 520 where the entire structure is annealed to sublimate and remove the second sacrificial material. The structure may be heated to a temperature between about 200 °C and 400 °C for anywhere from 30 minutes to 2 hours to cause sublimation of the second sacrificial material. The gaseous second sacrificial material may escape through the pores of the dielectric layer. As a result, an airgap remains in the volume previously occupied by the second sacrificial material and bounded by the dielectric liner and the dielectric layer. As noted above, the airgap may include trace amounts of gases such as nitrogen or argon. The airgap may be at a vacuum pressure following the removal of the second sacrificial material.

### Example System

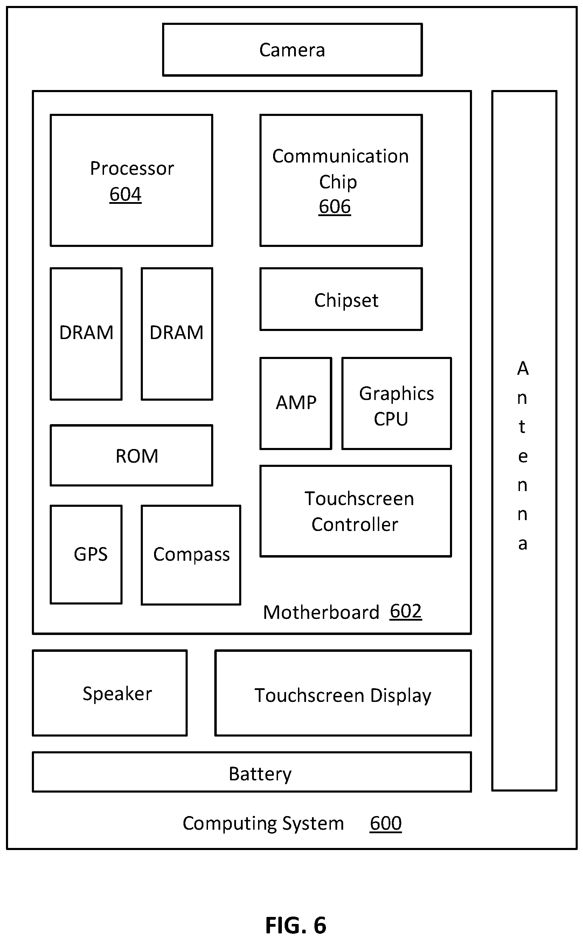

FIG. 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment, such as a module including an integrated circuit on a substrate, the substrate having forksheet transistor structures as variously described herein. In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multi-standard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor material extending in a first direction from a first source or drain region and a first gate structure extending in a second direction over the first semiconductor material, a second semiconductor device having a second semiconductor material extending in the first direction from a second source or drain region and a second gate structure extending in the second direction over the second semiconductor material, and a spine between the first semiconductor material and the second semiconductor material and between the first gate structure and the second gate structure. The spine includes a dielectric liner having a first portion on the first semiconductor material and a second portion on the second semiconductor material, and an airgap extending across the second direction from the first portion of the dielectric liner to the second portion of the dielectric liner.

Example 2 includes the integrated circuit of Example 1, wherein the first semiconductor material comprises first one or more semiconductor nanosheets and the second semiconductor material comprises second one or more semiconductor nanosheets.

Example 3 includes the integrated circuit of Example 2, wherein the first one or more semiconductor nanosheets and the second one or more semiconductor nanosheets comprise germanium, silicon, or both.

Example 4 includes the integrated circuit of any one of Examples 1-3, wherein the dielectric liner comprises silicon and nitrogen.

Example 5 includes the integrated circuit of any one of Examples 1-4, wherein the first semiconductor device further comprises a first gate dielectric at least partially around the first semiconductor material, and the second semiconductor device further comprises a second gate dielectric at least partially around the second semiconductor material.

Example 6 includes the integrated circuit of Example 5, where the first gate dielectric is directly on the first portion of the dielectric liner, and the first portion of the dielectric liner is directly on the first semiconductor material; and the second gate dielectric is directly on the second portion of the dielectric liner, and the second portion of the dielectric liner is directly on the second semiconductor material.

Example 7 includes the integrated circuit of Example 5 or 6, wherein the first gate dielectric and the second gate dielectric each comprise a high-k dielectric material.

Example 8 includes the integrated circuit of any one of Examples 1-7, wherein the spine further comprises a dielectric cap at a top portion of the spine, wherein the airgap is below the dielectric cap.

Example 9 includes the integrated circuit of Example 8, wherein the dielectric cap comprises a dielectric layer and a dielectric plug on the dielectric layer.

Example 10 includes the integrated circuit of Example 9, wherein the dielectric layer comprises a porous oxide material and the dielectric plug comprises silicon and nitrogen.

Example 11 includes the integrated circuit of Example 9 or 10, wherein the airgap directly abuts the dielectric layer.

Example 12 includes the integrated circuit of any one of Examples 1-11, wherein the airgap is under vacuum pressure.

Example 13 includes the integrated circuit of any one of Examples 1-12, wherein the spine extends along the first direction between the first source or drain region and the second source or drain region.

Example 14 is a die that includes the integrated circuit of any one of Examples 1-13.

Example 15 is an electronic device that includes a chip package having one or more dies. At least one of the one or more dies includes a first semiconductor material extending in a first direction between a first source or drain region and a second source or drain region, a first gate structure extending in a second direction over the first semiconductor material, a second semiconductor material extending in the first direction between a third source or drain region and a fourth source or drain region, a second gate structure extending in the second direction over the second semiconductor material, and a spine between the first semiconductor material and the second semiconductor material, between the first source or drain region and the third source or drain region, and between the second source or drain region and the fourth source or drain region. The spine includes a dielectric liner having a first portion on the first semiconductor material and a second portion on the second semiconductor material, and an airgap extending across the second direction from the first portion of the dielectric liner to the second portion of the dielectric liner.

Example 16 includes the electronic device of Example 15, wherein the first semiconductor material comprises first one or more semiconductor nanosheets and the second semiconductor material comprises second one or more semiconductor nanosheets.

Example 17 includes the electronic device of Example 16, wherein the first one or more semiconductor nanosheets and the second one or more semiconductor nanosheets comprise germanium, silicon, or both.

Example 18 includes the electronic device of any one of Examples 15-17, wherein the dielectric liner comprises silicon and nitrogen.

Example 19 includes the electronic device of any one of Examples 15-18, wherein the first gate structure comprises a first gate dielectric around the first semiconductor material and the second gate structure comprises a second gate dielectric around the second semiconductor material.

Example 20 includes the electronic device of Example 19, wherein the first gate dielectric is directly on the first portion of the dielectric liner, and the second gate dielectric is directly on the second portion of the dielectric liner.

Example 21 includes the electronic device of Example 19 or 20, wherein the first gate dielectric and the second gate dielectric each comprise a high-k dielectric material.

Example 22 includes the electronic device of any one of Examples 15-21, wherein the spine further comprises a dielectric cap at a top portion of the spine, wherein the airgap is below the dielectric cap.

Example 23 includes the electronic device of Example 22, wherein the dielectric cap comprises a dielectric layer and a dielectric plug on the dielectric layer.

Example 24 includes the electronic device of Example 23, wherein the dielectric layer comprises a porous oxide material and the dielectric plug comprises silicon and nitrogen.

Example 25 includes the electronic device of Example 23 or 24, wherein the airgap directly abuts the dielectric layer.

Example 26 includes the electronic device of any one of Examples 15-25, wherein the airgap is under vacuum pressure.

Example 27 includes the electronic device of any one of Examples 15-26, further comprising a printed circuit board, wherein the chip package is attached to the printed circuit board.

Example 28 is a method of forming an integrated circuit. The method includes forming a first fin comprising first semiconductor material and a second fin comprising second semiconductor material, wherein the first fin and the second fin are adjacent and extend parallel to one another along a first direction; forming a first sacrificial material between the first fin and the second fin such that the first sacrificial material extends from the first semiconductor material to the second semiconductor material along a second direction substantially orthogonal to the first direction; forming a sacrificial gate over the first fin and the second fin along the second direction; forming first source or drain regions at opposite ends of the first fin and second source or drain regions at opposite ends of the second fin; replacing the sacrificial gate with one or more gate structures that extend over the first semiconductor material and the second semiconductor material along the second direction; removing the first sacrificial material from between the first semiconductor material and the second semiconductor material to form a trench recess; forming a first dielectric liner within the trench recess; forming a second sacrificial material within a remaining volume of the trench recess on the dielectric liner; forming a second dielectric liner on at least a portion of a top surface of the second sacrificial material; and annealing the integrated circuit to remove the second sacrificial material while maintaining the second dielectric liner.

Example 29 includes the method of Example 28, wherein the first sacrificial material comprises silicon and oxygen.

Example 30 includes the method of Example 28 or 29, wherein the first fin comprises alternating layers of the first semiconductor material and first sacrificial layers and the second fin comprises alternating layers of the second semiconductor material and second sacrificial layers, and the method further includes removing the first sacrificial layers and the second sacrificial layers.

Example 31 includes the method of any one of Examples 28-30, wherein the second sacrificial material is more porous compared to the first sacrificial material.

Example 32 includes the method of any one of Examples 28-31, wherein the annealing comprises annealing at a temperature between 200 °C and 400 °C.

Example 33 includes the method of any one of Examples 28-32, further comprising forming a dielectric layer on the dielectric liner after the annealing.

Example 34 is an integrated circuit that includes a first semiconductor device having first semiconductor material, a second semiconductor device having second semiconductor material, and a spine between and contacting the first semiconductor material and the second semiconductor material. The spine includes a first dielectric liner along sidewalls of the spine, a second dielectric liner at a top portion of the spine, and a region devoid of solid material within a central portion of the spine and bound by the first dielectric liner and the second dielectric liner.

Example 35 includes the integrated circuit of Example 34, wherein the first semiconductor material comprises first one or more semiconductor nanosheets and the second semiconductor material comprises second one or more semiconductor nanosheets.

Example 36 includes the integrated circuit of Example 35, wherein the first one or more semiconductor nanosheets and the second one or more semiconductor nanosheets comprise germanium, silicon, or both.

Example 37 includes the integrated circuit of any one of Examples 34-36, wherein the first dielectric liner comprises silicon and nitrogen.

Example 38 includes the integrated circuit of any one of Examples 34-37, wherein the first semiconductor device further comprises a first gate dielectric around the first semiconductor material, and the second semiconductor device further comprises a second gate dielectric around the second semiconductor material.

Example 39 includes the integrated circuit of Example 38, wherein the first gate dielectric is directly on at least a portion of the first dielectric liner and the second gate dielectric is directly on at least a portion of the first dielectric liner.

Example 40 includes the integrated circuit of Example 38 or 39, wherein the first gate dielectric and the second gate dielectric each comprise a high-k dielectric material.

Example 41 includes the integrated circuit of any one of Examples 34-40, wherein the spine further comprises a dielectric plug on the second dielectric liner.

Example 42 includes the integrated circuit of Example 41, wherein the second dielectric liner comprises a porous oxide material and the dielectric plug comprises silicon and nitrogen.

Example 43 includes the integrated circuit of any one of Examples 34-42, wherein the region devoid of solid material directly abuts both the first dielectric liner and the second dielectric liner.

Example 44 includes the integrated circuit of any one of Examples 34-43, wherein the first semiconductor material extends in a first direction from a first source or drain region and the second semiconductor material extends in the first direction from a second source or drain region, and the spine extends in the first direction between the first source or drain region and the second source or drain region.

Example 45 includes the integrated circuit of any one of Examples 34-44, wherein the region devoid of solid material is under vacuum pressure.

Example 46 includes the integrated circuit of any one of Examples 34-45, wherein the spine directly contacts the first semiconductor material and the second semiconductor material.

Example 47 is a die that includes the integrated circuit of any one of Examples 34-46.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor material extending in a first direction from a first source or drain region, and a first gate structure extending in a second direction over the first semiconductor material;
a second semiconductor device having a second semiconductor material extending in the first direction from a second source or drain region, and a second gate structure extending in the second direction over the second semiconductor material; and
a spine between the first semiconductor material and the second semiconductor
material and between the first gate structure and the second gate structure, wherein the spine comprises
a dielectric liner having a first portion adjacent to the first semiconductor material and a second portion adjacent to the second semiconductor material; and
an airgap extending across the second direction from the first portion of the dielectric liner to the second portion of the dielectric liner.

2. The integrated circuit of claim 1, wherein the first semiconductor material comprises first one or more semiconductor nanosheets and the second semiconductor material comprises second one or more semiconductor nanosheets.

3. The integrated circuit of claim 2, wherein the first one or more semiconductor nanosheets and the second one or more semiconductor nanosheets comprise germanium, silicon, or both.

4. The integrated circuit of any one of claims 1 through 3, wherein the dielectric liner comprises silicon and nitrogen.

5. The integrated circuit of any one of claims 1 through 4, wherein the first semiconductor device further comprises a first gate dielectric at least partially around the first semiconductor material, and the second semiconductor device further comprises a second gate dielectric at least partially around the second semiconductor material.

6. The integrated circuit of claim 5, wherein:
the first gate dielectric is directly on the first portion of the dielectric liner, and the first portion of the dielectric liner is directly on the first semiconductor material; and
the second gate dielectric is directly on the second portion of the dielectric liner, and the second portion of the dielectric liner is directly on the second semiconductor material.

7. The integrated circuit of claim 5 or 6, wherein the first gate dielectric and the second gate dielectric each comprise a high-k dielectric material.

8. The integrated circuit of any one of claims 1 through 7, wherein the spine further comprises a dielectric cap at a top portion of the spine, wherein the airgap is below the dielectric cap.

9. The integrated circuit of claim 8, wherein the dielectric cap comprises a dielectric layer and a dielectric plug on the dielectric layer.

10. The integrated circuit of claim 9, wherein the dielectric layer comprises a porous oxide material and the dielectric plug comprises silicon and nitrogen.

11. The integrated circuit of claim 9 or 10, wherein the airgap directly abuts the dielectric layer.

12. The integrated circuit of any one of claims 1 through 11, wherein the spine extends along the first direction between the first source or drain region and the second source or drain region.

13. A die comprising the integrated circuit of any one of claims 1 through 12.

14. A method of forming an integrated circuit, the method comprising:
forming a first fin comprising first semiconductor material and a second fin comprising second semiconductor material, wherein the first fin and the second fin are adjacent and extend parallel to one another along a first direction;
forming a first sacrificial material between the first fin and the second fin such that the first sacrificial material extends from the first semiconductor material to the second semiconductor material along a second direction substantially orthogonal to the first direction;
forming a sacrificial gate over the first fin and the second fin along the second direction;
forming first source or drain regions at opposite ends of the first fin and second source or drain regions at opposite ends of the second fin;
replacing the sacrificial gate with one or more gate structures that extend over the first semiconductor material and the second semiconductor material along the second direction;
removing the first sacrificial material from between the first semiconductor material and the second semiconductor material to form a trench recess;
forming a first dielectric liner within the trench recess;
forming a second sacrificial material within a remaining volume of the trench recess on the dielectric liner;
forming a second dielectric liner on at least a portion of a top surface of the second sacrificial material; and
annealing the integrated circuit to remove the second sacrificial material while maintaining the second dielectric liner.

15. The method of claim 14, wherein the first sacrificial material comprises silicon and oxygen, the second sacrificial material is more porous compared to the first sacrificial material, the annealing comprises annealing at a temperature between 200 °C and 400 °C, and the first fin comprises alternating layers of the first semiconductor material and first sacrificial layers and the second fin comprises alternating layers of the second semiconductor material and second sacrificial layers, and the method further comprises:
removing the first sacrificial layers and the second sacrificial layers; and
forming a dielectric layer on the dielectric liner after the annealing.
